# EUROPÄISCHE PATENTANMELDUNG

(11) **EP 0 883 185 A1**
(43) Veröffentlichungstag der Anmeldung: **09.12.1998**
(21) Anmeldenummer: 98110034.0
(22) Anmeldetag: 02.06.1998
(51) Int. Cl.: H01L 27/108, H01L 29/78, H01L 21/8242

(54) **Selbstverstärkende DRAM-Zellenanordnung und Verfahren zu deren Herstellung**

(30) Priorität: 06.06.1997 DE 19723936
(71) Anmelder: SIEMENS AKTIENGESELLSCHAFT, 80333 München (DE)
(72) Erfinder: Bertagnolli, Emmerich, Prof., 80799 München (DE); Göbel, Bernd, 81735 München (DE)

(57) **Zusammenfassung**

Die DRAM-Zellenanordnung umfaßt pro Speicherzelle drei Transistoren, von denen mindestens einer als vertikaler Transistor ausgebildet ist. Die Transistoren können an Flanken von ersten Gräben und zweiten Gräben ausgebildet sein, wobei schreibende Wortleitungen entlang erster Flanken der ersten Gräben, auslesende Wortleitungen entlang erster Flanken der zweiten Gräben und Bitleitungen (B) oberhalb und quer zu den Wortleitungen verlaufen, und dritte erste Source/Drain-Gebiete (3S/D1) und erste zweite Source/Drain-Gebiete (1S/D2) sowie dritte zweite Source/Drain-Gebiete (3S/D2) und zweite zweite Source/Drain-Gebiete (2S/D2) zusammenfallen.

## Beschreibung

Die Erfindung betrifft eine DRAM-Zellenanordnung, d.h. eine Speicherzellen-Anordnung mit dynamischem wahlfreiem Zugriff, bei der eine Speicherzelle drei Transistoren umfaßt.

In DRAM-Zellenanordnungen werden derzeit fast ausschließlich sog. Eintransistor-Speicherzellen eingesetzt. Eine Eintransistor-Speicherzelle umfaßt einen Auslesetransistor und einen Speicherkondensator. In dem Speicherkondensator ist die Information in Form einer elektrischen Ladung gespeichert, die eine logische Größe, 0 oder 1, darstellt. Durch Ansteuerung des Auslesetransistors über eine Wortleitung kann diese Information über eine Bitleitung ausgelesen werden. Die im Speicherkondensator gespeicherte elektrische Ladung treibt dabei die Bitleitung.

Da von Speichergeneration zu Speichergeneration die Speicherdichte zunimmt, muß die benötigte Fläche der Eintransistor-Speicherzelle von Generation zu Generation reduziert werden. Dies führt zu grundlegenden technologischen und physikalischen Problemen. Beispielsweise muß der Speicherkondensator trotz kleinerer Fläche der Eintransistor-Speicherzelle eine Mindestmenge an elektrischer Ladung speichern können, um damit die Bitleitung treiben zu können.

Dieses Problem wird in einer alternativen DRAM-Zellenanordnung, in der als Speicherzellen sog. Gainzellen eingesetzt werden, umgangen. Auch hier ist die Information in Form einer elektrischen Ladung gespeichert. Die elektrische Ladung muß jedoch nicht direkt eine Bitleitung treiben, sondern wird in einer Gateelektrode eines Transistors gespeichert und dient nur zu dessen Steuerung, wozu schon eine sehr kleine Menge an elektrischer Ladung genügt.

In M. Heshami, 1996 IEEE J. of Solid-State Circuits, Vol. 31, No.3 wird eine Gainzelle, die drei Transistoren umfaßt, beschrieben. Die elektrische Ladung wird in einer Gateelektrode eines ersten Transistors gespeichert. Das Speichern der elektrischen Ladung geschieht mit Hilfe eines zweiten Transistors. Die Gateelektrode des ersten Transistors ist mit einem ersten Source/Drain-Gebiet des zweiten Transistors und ein zweites Source/Drain-Gebiet des zweiten Transistors mit einer schreibenden Bitleitung verbunden. Zum Speichern wird eine Gateelektrode des zweiten Transistors über eine schreibende Wortleitung angesteuert. Die Menge an elektrischer Ladung und damit die Information, die dabei in der Gateelektrode des ersten Transistors gespeichert wird, wird durch eine Spannung an der schreibenden Bitleitung bestimmt. Das Auslesen der Information geschieht mit Hilfe eines dritten Transistors. Ein zweites Source/Drain-Gebiet des ersten Transistors ist mit einem ersten Source/Drain-Gebiet des dritten Transistors und ein zweites Source/Drain-Gebiet des dritten Transistors mit einer auslesenden Bitleitung verbunden. Zum Auslesen wird eine Gateelektrode des dritten Transistors über eine auslesende Wortleitung angesteuert. Die Menge an elektrischer Ladung, und damit die Information, wird über die auslesende Bitleitung ausgelesen.

Der Erfindung liegt das Problem zugrunde, eine DRAM-Zellenanordnung anzugeben, die als Speicherzellen Gainzellen mit jeweils drei Transistoren umfaßt und mit besonders hoher Packungsdichte herstellbar ist. Ferner soll ein Herstellungsverfahren für eine solche DRAM-Zellenanordnung angegeben werden.

Dieses Problem wird gelöst durch eine DRAM-Zellenanordnung gemäß Anspruch 1 sowie ein Verfahren zu deren Herstellung gemäß Anspruch 9. Weitere Ausgestaltungen der Erfindung gehen aus den übrigen Ansprüchen hervor.

In einer erfindungsgemäßen DRAM-Zellenanordnung ist mindestens ein Transistor einer Speicherzelle als ein vertikaler Transistor ausgebildet. Es ist vorteilhaft alle drei Transistoren der Speicherzelle als vertikale Transistoren auszubilden, da die Fläche der Speicherzelle dadurch besonders klein wird.

Es liegt im Rahmen der Erfindung, die drei Transistoren an Flanken eines ersten Grabens und eines zweiten Grabens, die im wesentlichen zueinander parallel verlaufen, auszubilden. Die Verbindung der Gateelektrode des ersten Transistors, in der die Information gespeichert wird, mit dem ersten Source/Drain-Gebiet des zweiten Transistors erfolgt über eine leitende Struktur, die beispielsweise innerhalb des ersten Grabens an eine zweite Flanke angrenzt, an der keiner der drei Transistoren ausgebildet ist.

Damit entlang Flanken der ersten Gräben und der zweiten Gräben zwischen benachbarten, von einem ersten Leitfähigkeitstyp dotierten Source/Drain-Gebieten verschiedener Transistoren keine Ströme fließen, können durch schräge Implantation an den Flanken der ersten Gräben und der zweiten Gräben zwischen den Transistoren hochdotierte Channel-Stop-Gebiete erzeugt werden. Die Channel-Stop-Gebiete sind von einem zweiten, zum ersten Leitfähigkeitstyp entgegengesetzten Leitfähigkeitstyp dotiert.

Zur Verkleinerung der Fläche einer Speicherzelle ist es vorteilhaft, wenn Source/Drain-Gebiete benachbarter Transistoren, die miteinander elektrisch verbunden sein sollen, zusammenfallen.

Es liegt im Rahmen der Erfindung zur Verbesserung verschiedener Eigenschaften der DRAM-Zellenanordnung, zusätzlich zu den drei Transistoren der Speicherzelle weitere Bauelemente, wie z.B. Kondensatoren, in die Speicherzelle zu integrieren.

Aufgrund von Leckströmen, muß die Information in regelmäßigen Zeitabständen neu auf die Gateelektroden der ersten Transistoren geschrieben werden. Um die Zeitabstände zu vergrößern, ist es vorteilhaft, die Speicherzellen jeweils mit einem Kondensator zu versehen, dessen erste Kondensatorplatte mit der Gateelektrode des ersten Transistors verbunden ist.

Im folgenden wird die Erfindung anhand der Ausführungsbeispiele, die in den Figuren dargestellt sind, näher erläutert.
- Figur 1: zeigt eine Oberfläche eines ersten Substrats, die in erste Bereiche, die dritte Bereiche umfassen, und zweite Bereiche, die vierte Bereiche umfassen, unterteilt ist. Es wurden erste Gräben und zweite Gräben erzeugt.
- Figur 2a: zeigt einen ersten Querschnitt entlang der Mittellinie eines ersten Bereichs durch das in einer Schicht dotierte erste Substrat, nachdem eine erste isolierende Schicht, erste Gräben, zweite Gräben, erste Source/Drain-Gebiete von ersten Transistoren, zweite Source/Drain-Gebiete von zweiten Transistoren, zweite Source/Drain-Gebiete von dritten Transistoren, erste Channel-Stop-Gebiete und zweite Channel-Stop-Gebiete erzeugt wurden.
- Figur 2b: zeigt das Substrat aus Figur 2a in einem zum ersten Querschnitt parallelen zweiten Querschnitt entlang der Mittellinie eines der zweiten Bereiche.
- Figur 3: zeigt den Querschnitt aus Figur 2b, nachdem erste Source/Drain-Gebiete der zweiten Transistoren, erste Source/Drain-Gebiete der dritten Transistoren, zweite Source/Drain-Gebiete der ersten Transistoren, ein Gatedielektrikum, Gateelektroden der ersten Transistoren, Gateelektroden der zweiten Transistoren und Gateelektroden der dritten Transistoren erzeugt wurden.
- Figur 4: zeigt den Querschnitt aus Figur 2a, nachdem erste Source/Drain-Gebiete der zweiten Transistoren, erste Source/Drain-Gebiete der dritten Transistoren, zweite Source/Drain-Gebiete der ersten Transistoren, ein Gatedielektrikum, erste Gateelektroden, Gateelektroden der zweiten Transistoren, Gateelektroden der dritten Transistoren, eine erste isolierende Struktur und eine zweite isolierende Struktur erzeugt wurden.
- Figur 5: zeigt den Querschnitt aus Figur 4, nachdem leitende Strukturen, die jeweils eine Gateelektrode eines ersten Transistors mit einem ersten Source/Drain-Gebiet eines zweiten Transistors verbindet, erzeugt wurden.
- Figur 6: zeigt den Querschnitt aus Figur 5, nachdem Bitleitungen und Kontakte der Bitleitungen erzeugt wurden.
- Figur 7: zeigt einen zum Querschnitt in Figur 2a analogen Querschnitt durch ein in einer Schicht dotiertes zweites Substrat, nachdem ein erstes Gebiet implantiert wurde und eine erste isolierende Schicht, eine leitende Schicht und eine zweite isolierende Schicht abgeschieden wurden.

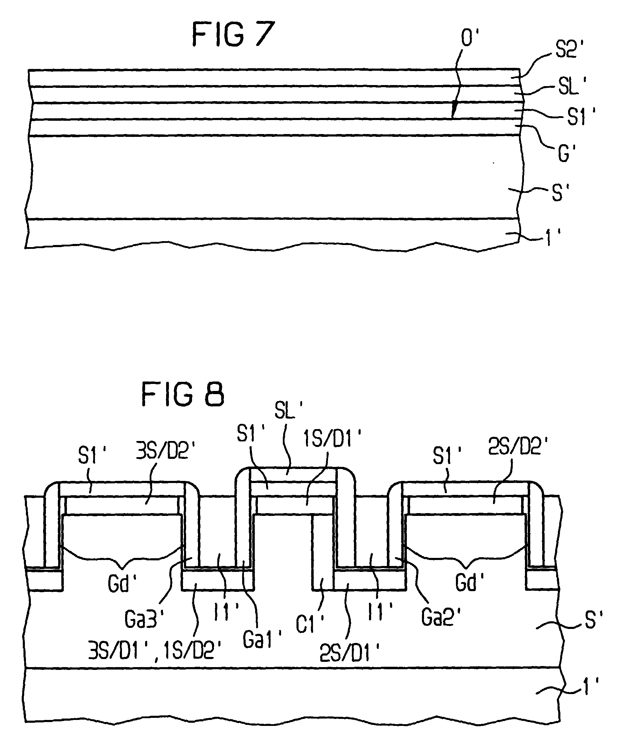

- Figur 8: zeigt den Querschnitt aus Figur 7, nachdem erste Gräben, zweite Gräben, erste Source/Drain-Gebiete der ersten Transistoren, zweite Source/Drain-Gebiete der zweiten Transistoren, zweite Source/Drain-Gebiete der dritten Transistoren, Channel-Stop-Gebiete, erste Source/Drain-Gebiete der zweiten Transistoren, erste Source/Drain-Gebiete der dritten Transistoren, zweite Source/Drain-Gebiete der ersten Transistoren, ein Gatedielektrikum, Gateelektroden der ersten Transistoren, Gateelektroden der zweiten Transistoren, Gateelektroden der dritten Transistoren und eine erste isolierende Struktur erzeugt wurden.
- Figur 9: zeigt den Querschnitt aus Figur 8, nachdem eine zweite isolierende Struktur und eine leitende Struktur erzeugt wurden.
- Figur 10: zeigt einen zum Querschnitt aus Figur 2b analogen Querschnitt durch ein drittes Substrat, nachdem eine erste isolierende Schicht, eine leitende Schicht und mit *SiO*₂ gefüllte erste Gräben und zweite Gräben erzeugt wurden.

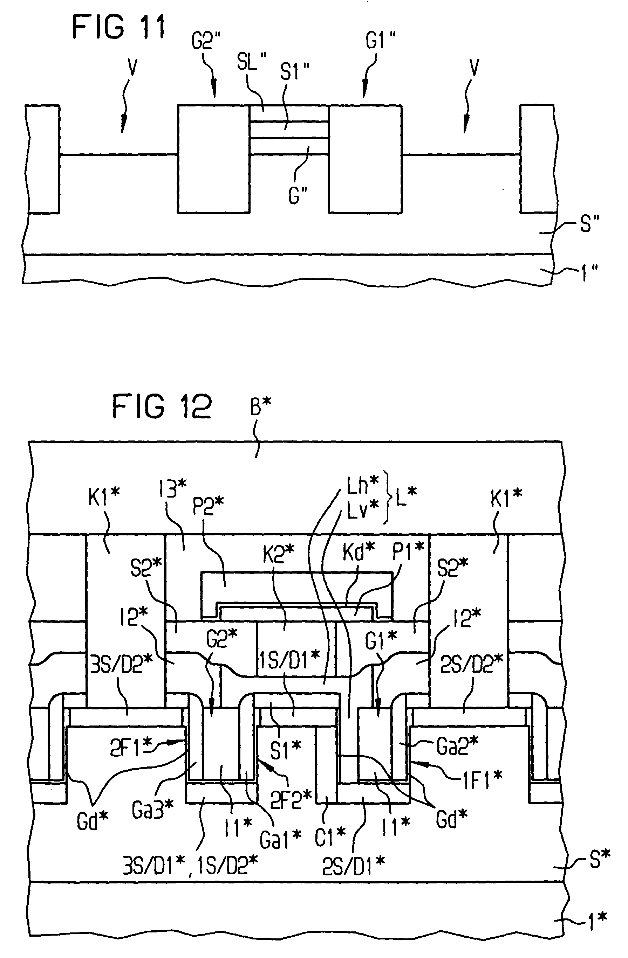

- Figur 11: zeigt den Querschnitt aus Figur 11, nachdem Vertiefungen erzeugt wurden.
- Figur 12: zeigt einen zum Querschnitt aus Figur 6 analogen Querschnitt durch ein viertes Substrat nach Fertigstellung der DRAM-Zellenanordnung, deren Speicherzellen jeweils drei vertikale Transistoren und einen Kondensator umfassen.

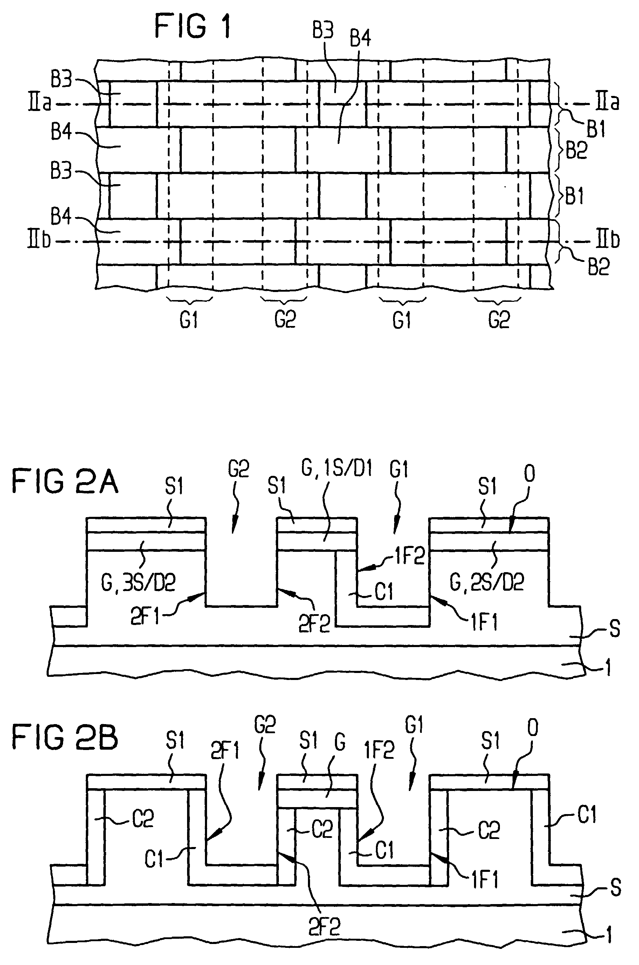

Gemäß eines ersten Ausführungsbeispiels ist ein erstes Substrat 1 aus Silizium in einer an eine Oberfläche O des ersten Substrats 1 angrenzenden ca. 2*µm* dicken Schicht S, p-dotiert. Die Dotierstoffkonzentration beträgt ca. 10¹⁷cm⁻³. Die Oberfläche O umfaßt erste Bereiche B1 und zweite Bereiche B2 (s. Fig. 1 u. Fig. 2). Die ersten Bereiche B1 und die zweiten Bereiche B2 haben die Form von ca. 0,5*µm* breiten Streifen und verlaufen parallel zueinander. Die ersten Bereiche B1 und die zweiten Bereiche B2 sind abwechselnd nebeneinander angeordnet und grenzen aneinander an. Die ersten Bereiche B1 umfassen rechteckige dritte Bereiche B3 mit einer Breite von ca. 0,5*µm* und einer Länge von ca. 0,5*µm* (s. Fig. 1). Der Abstand zwischen den Mitten benachbarter dritter Bereiche B3 eines ersten Bereichs B1 beträgt ca. 2,25*µm*. Der kleinste Abstand zwischen benachbarten dritten Bereichen B3 benachbarter erster Bereiche B1 beträgt ca. 1*µm*. Mit Hilfe einer ersten Photolackmaske (nicht dargestellt), die ca. 1*µm* lange und ca. 0,5*µm* breite vierte Bereiche B4 (s. Fig. 1), die innerhalb der zweiten Bereiche B2 zwischen den dritten Bereichen B3 angeordnet sind, bedeckt, wird durch Implantation ein n-dotiertes ca. 150 nm tiefes Gebiet G erzeugt (s. Fig 2a und 2b). Die Dotierstoffkonzentration des Gebiets G beträgt ca. 5*10²⁰cm⁻³.

Auf der Oberfläche O wird eine erste isolierende Schicht S1 aus SiO₂ abgeschieden und mit Hilfe einer zweiten Photolackmaske (nicht dargestellt) durch anisotropes Ätzen strukturiert (s. Fig 2a und 2b). Als Ätzmittel ist z.B. *CHF*₃+*O*₂ geeignet. Durch anisotropes Ätzen von Silizium selektiv zu SiO₂ werden erste Gräben G1 und zweite Gräben G2, die quer zu den ersten Bereichen B1 und den zweiten Bereichen B2 parallel zueinander verlaufen, erzeugt (s. Fig. 2a und 2b). Als Maske dient die strukturierte erste isolierende Schicht S1. Als Ätzmittel ist *HBrF* geeignet. Die ersten Gräben G1 und die zweiten Gräben G2 sind ca. 0,6*µm* tief, 0,5*µm* weit und 500*µm* lang und sind abwechselnd nebeneinander angeordnet. Der kürzeste Abstand zwischen der Mittellinie eines ersten Grabens G1 und der Mitte eines dritten Bereichs B3 und der kürzeste Abstand zwischen der Mittellinie eines zweiten Grabens G2 und der Mitte eines dritten Bereichs B3 betragen ca. 625 nm. Innerhalb der dritten Bereiche B3 übrigbleibende Teile des Gebiets G sind als zweite Source/Drain-Gebiete 2S/D2 von zweiten Transistoren und gleichzeitig als zweite Source/Drain-Gebiete 3S/D2 von dritten Transistoren geeignet. Innerhalb der ersten Bereiche B1 zwischen den dritten Bereichen B3 übrigbleibende Teile des Gebiets G sind als erste Source/Drain-Gebiete 1S/D1 von ersten Transistoren geeignet. Innerhalb der zweiten Bereiche B2 übrigbleibende Teile des Gebiets G verbinden erste Source/Drain-Gebiete 1S/D1 von entlang der zweiten Gräben G2 benachbarten ersten Transistoren miteinander.

Mit Hilfe einer dritten Photolackmaske, die die ersten Bereiche B1 sowie die ersten Gräben G1 nicht bedeckt, werden durch Implantation p-dotierte erste Channel-Stop-Gebiete C1 erzeugt (s. Fig 2a). Die Implantation erfolgt schräg, so, daß die ersten Channel-Stop-Gebiete C1 an zweite Flanken 1F2 der ersten Gräben G1 und an innerhalb der zweiten Bereiche B2 befindliche Teile erster Flanken 2F1 der zweiten Gräben G2 angrenzen. An den zweiten Flanken des ersten Grabens G1 und an den ersten Flanken der zweiten Gräben G2 beträgt die Weite der ersten Channel-Stop-Gebiete C1 ca. 100 nm. Die Dotierstoffkonzentration der ersten Channel-Stop-Gebiete C1 beträgt ca. 10¹⁹cm⁻³.

Mit Hilfe einer vierten Photolackmaske (nicht dargestellt), die die zweiten Bereiche B2 nicht bedeckt, werden durch Implantation p-dotierte zweite Channel-Stop-Gebiete C2 erzeugt (s. Figur 2b). Die Implantation erfolgt schräg, so, daß die zweiten Channel-Stop-Gebiete C2 an erste Flanken 1F1 der ersten Gräben G1 und an den zweiten Flanken 2F2 der zweiten Gräben G2 angrenzen. An den ersten Flanken 1F1 der ersten Gräbens G1 und an den zweiten Flanken 2F2 der zweiten Gräben G2 beträgt die Weite der zweiten Channel-Stop-Gebiete C2 ca. 100nm. Die Dotierstoffkonzentration der zweiten Channel-Stop-Gebiete C2 beträgt ca. 10⁹cm⁻³.

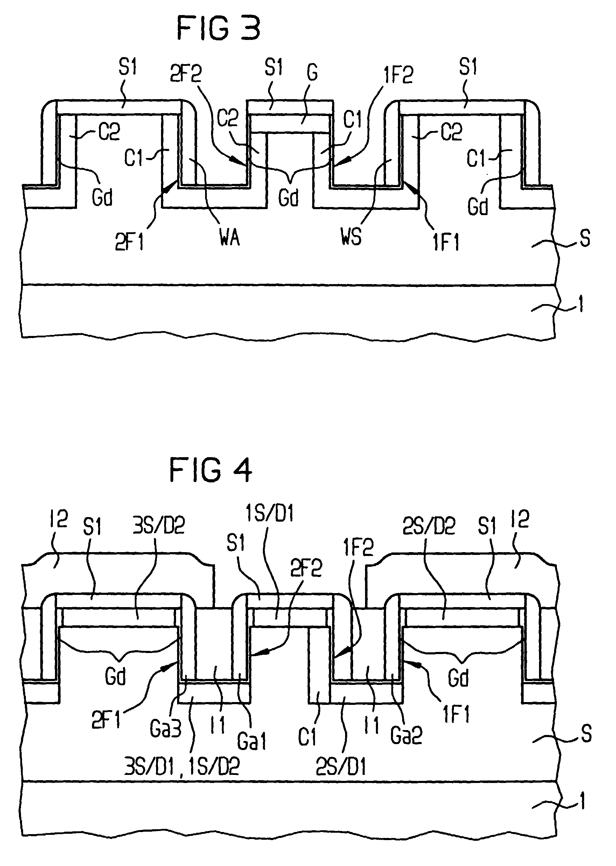

Mit Hilfe einer fünften Photolackmaske (nicht dargestellt), die die zweiten Bereiche B2 bedeckt, werden durch Implantation an Böden der ersten Gräben G1 angrenzende erste Source/Drain-Gebiete 2S/D1 der zweiten Transistoren und an Böden der zweiten Gräben G2 angrenzende erste Source/Drain-Gebiete 3S/D1 der dritten Transistoren, die gleichzeitig zweite Source/Drain-Gebiete 1S/D2 der ersten Transistoren sind, erzeugt (s. Fig 4). Ein anschließendes RTP-Verfahren aktiviert den Dotierstoff des ersten Source/Drain-Gebiets 2S/D1 der zweiten Transistors und des ersten Source/Drain-Gebiets 3S/D1 des dritten Transistors. Das erste Source/Drain-Gebiet 2S/D1 des zweiten Transistors und das erste Source/Drain-Gebiet 3S/D1 des dritten Transistors sind n-dotiert und weisen eine Dotierstoffkonzentration von ca. 5*10²⁰cm⁻³ auf.

Durch thermische Oxidation wird ein Gatedielektrikum Gd erzeugt, das die ersten Flanken 1F1, die zweiten Flanken 1F2 und einen Boden des ersten Grabens G1 und die ersten Flanken 1F2, die zweiten Flanken 2F2 und einen Boden des zweiten Grabens G2 bedeckt (s. Fig. 3).

Anschließend wird dotiertes Polysilizium mit einer Dicke von ca. 150 nm abgeschieden und rückgeätzt, so daß an den Flanken des ersten Grabens G1 und des zweiten Grabens G2 Spacer entstehen (s. Fig. 3, 4). Als Ätzmittel ist z.B. *C*₂*F*₆+*O*₂ geeignet. Spacer an den ersten Flanken 1F1 der ersten Gräben G1 wirken als schreibende Wortleitungen WS. Spacer an den ersten Flanken 2F1 der zweiten Gräben G2 wirken als auslesende Wortleitungen WA. Erste Teile der Spacer, die innerhalb der ersten Bereiche B1 angeordnet sind und an die zweiten Flanken 2F2 der zweiten Gräben G2 angrenzen, wirken als Gateelektroden Ga1 der ersten Transistoren. Teile der schreibenden Wortleitungen WS, die innerhalb der ersten Bereiche B1 angeordnet sind, wirken als Gateelektroden Ga2 der zweiten Transistoren. Teile der auslesenden Wortleitungen WA, die innerhalb der ersten Bereiche B1 angeordnet sind, wirken als Gateelektroden Ga3 der dritten Transistoren. Mit Hilfe einer sechsten Photolackmaske (nicht dargestellt), die in den zweiten Bereichen B2 die zweiten Flanken 1F2 der ersten Gräben G1 und die zweiten Flanken 2F2 der zweiten Gräben G2 nicht bedeckt, werden durch Ätzen von Polysilizium zweite Teile von Spacern entfernt, so, daß Gateelektroden Ga1 von entlang der zweiten Gräben G2 benachbarten ersten Transistoren voneinander isoliert werden (siehe Figur 3 und 4). Spacer, die an die ersten Channel-Stop-Gebiete C1 und an die zweiten Channel-Stop-Gebiete C2 angrenzen, können aufgrund der hohen Dotierstoffkonzentration der ersten Channel-Stop-Gebiete C1 und der zweiten Channel-Stop-Gebiete C2 keine Kanalströme in den ersten Channel-Stop-Gebieten C1 und in den zweiten Channel-Stop-Gebieten C2 auslösen. Kanalbereiche benachbarter zweiter Transistoren sowie Kanalbereiche benachbarter dritter Transistoren sind dadurch voneinander getrennt.

Zur Bildung einer ersten isolierenden Struktur I1, werden die ersten Gräben G1 und die zweiten Gräben G2 mit SiO₂ gefüllt, indem SiO₂ abgeschieden und dann isotrop rückgeätzt (s. Fig 4).

Mit einer Dicke von ca. 250 nm wird SiO₂ abgeschieden und anschließend mit Hilfe einer siebten Photolackmaske (nicht dargestellt), die innerhalb der ersten Bereiche B1 die zweiten Flanken 1F2 der ersten Gräben G1 und die zweiten Flanken 2F2 der zweiten Gräben G2 nicht bedeckt, geätzt, wodurch eine zweite isolierende Struktur I2 entsteht (s. Fig 4).

Anschließend wird mit Hilfe einer achten Photolackmaske (nicht dargestellt), die innerhalb der ersten Bereiche B1 die zweiten Flanken 1F2 der ersten Gräben G1 nicht bedeckt, zunächst Polysilizium mit z.B. *C*₂*F*₆+*O*₂ und dann SiO₂ mit z.B. *CHF*₃+*O*₂ geätzt, so, daß Spacer an den zweiten Flanken 1F2 der ersten Gräben G1 entfernt werden und ein Teil des Bodens der ersten Gräben G1 freigelegt wird.

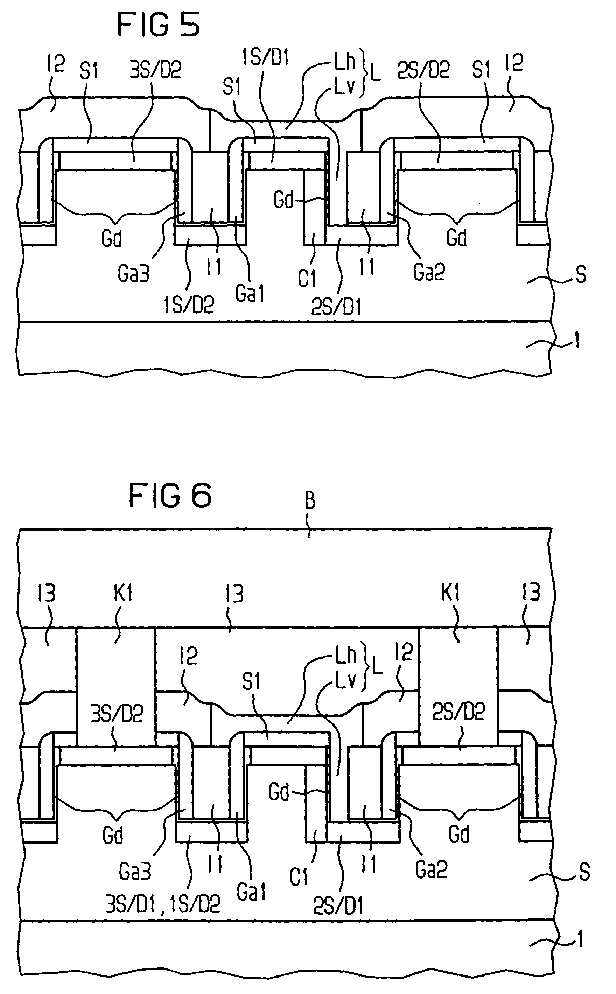

Anschließend wird dotiertes Polysilizium mit einer Dicke von ca. 150 nm abgeschieden. Mit Hilfe einer neunten Photolackmaske (nicht dargestellt), die in den ersten Bereichen B1 die zweiten Flanken 1F2 der ersten Gräben G1 und die zweiten Flanken 2F2 der zweiten Gräben G2 bedeckt, wird Polysilizium geätzt, wodurch leitende Strukturen L mit einem horizontalen Element Lh und einem vertikalen Element Lv entstehen, die jeweils eine Gateelektrode Ga1 des ersten Transistors mit dem zugehörigen ersten Source/Drain-Gebiet 2S/D1 des zweiten Transistors verbinden (s. Fig 5).

Anschließend wird eine dritte isolierende Struktur I3 erzeugt, indem SiO₂ mit einer Dicke von ca. 500 nm abgeschieden und mit Hilfe einer zehnten Photolackmaske (nicht dargestellt), die die dritten Bereiche B3 nicht bedeckt, geätzt wird, bis Teile der zweiten Source/Drain-Gebiete 3S/D2 der dritten Transistoren freigelegt werden (s. Fig 6). Dann wird z.B. Wolfram abgeschieden und rückgeätzt, wodurch erste Kontakte K1 von zu erzeugenden Bitleitungen B entstehen. Als Ätzmittel ist z.B. SF₆ geeignet. Die Bitleitungen B sind streifenförmig und verlaufen quer zu den schreibenden Wortleitungen WS und auslesenden Wortleitungen WA parallel zueinander.

Zur Erzeugung der Bitleitungen B wird zunächst z.B. Aluminium abgeschieden und anschließend mit Hilfe einer elften Photolackmaske (nicht dargestellt), die die zweiten Bereiche B2 nicht bedeckt, strukturiert (s. Fig 6).

In einem zweiten Ausführungsbeispiel ist ein zweites Substrat 1' aus Silizium in einer an eine Oberfläche O' des zweiten Substrats 1' angrenzenden ca. 2*µm* dicken Schicht S' p-dotiert. Die Dotierstoffkonzentration beträgt ca. 10¹⁷cm⁻³ Analog zum ersten Ausführungsbeispiel umfaßt die Oberfläche O' des zweiten Substrats 1' erste Bereiche und zweite Bereiche. Analog zum ersten Ausführungsbeispiel umfassen die ersten Bereiche dritte Bereiche und die zweiten Bereiche vierte Bereiche. Wie im ersten Ausführungsbeispiel wird durch Implantation ein n-dotiertes ca. 150 nm tiefes Gebiet G' erzeugt. Anschließend wird eine ca. 150 nm dicke erste isolierende Schicht S1' aus SiO₂ abgeschieden. Darüber wird eine leitende Schicht SL' aus Polysilizium abgeschieden. Darüber wird eine ca. 200 nm dicke zweite isolierende Schicht S2' aus SiO₂ abgeschieden (s. Fig 7).

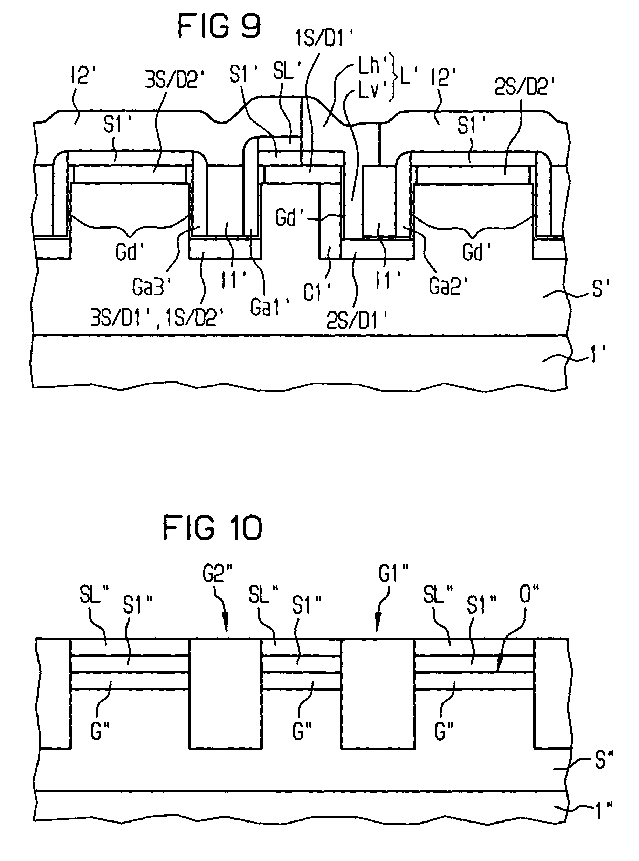

Anschließend werden wie im ersten Ausführungsbeispiel erste Gräben G1', zweite Gräben G2', erste Source/Drain-Gebiete 1S/D1' von ersten Transistoren, zweite Source/Drain-Gebiete 3S/D2' von dritten Transistoren und zweite Source/Drain-Gebiete 2S/D2' von zweiten Transistoren erzeugt. Dann werden übrigbleibende Teile der zweiten isolierenden Schicht S2' durch Ätzen von SiO₂ selektiv zu Silizium entfernt. Anschließend werden wie im ersten Ausführungsbeispiel erste Channel-Stop-Gebiete C1', zweite Channel-Stop-Gebiete, erste Source-Drain-Gebiete 2S/D1' der zweiten Transistoren, erste Source-Drain-Gebiete 3S/D1' der dritten Transistoren, zweite Source-Drain-Gebiete 1S/D2' der ersten Transistoren, ein Gatedielektrikum Gd', Gateelektroden Ga1' der ersten Transistoren, Gateelektroden Ga2' der zweiten Transistoren, Gateelektroden Ga3' der dritten Transistoren, schreibende Wortleitungen und auslesende Wortleitungen erzeugt. Wie im ersten Ausführungsbeispiel werden Gateelektroden Ga1' von entlang-der zweiten Gräben G2' benachbarten erste Transistoren mit Hilfe einer sechsten Photolackmaske voneinander isoliert. Wie im ersten Ausführungsbeispiel werden anschließend die ersten Gräben G1' und die zweiten Gräben G2' mit einer ersten isolierenden Struktur I1' aus SiO₂ gefüllt. Mit Hilfe einer zwölften Photolackmaske (nicht dargestellt), die in den ersten Bereichen die zweiten Flanken der ersten Gräben G1' und die zweiten Flanken der zweiten Gräben G2' bedeckt, wird Polysilizium selektiv zu SiO₂ geätzt (s. Fig 8). Anschließend wird eine zweite isolierende Struktur I2' erzeugt, indem SiO₂ abgeschieden und mit Hilfe einer dreizehnten Photolackmaske (nicht dargestellt), die in den ersten Bereichen die zweiten Flanken der ersten Gräben G1' nicht bedeckt, SiO₂ geätzt wird, bis ein Teil der leitenden Schicht SL' freigelegt wird. Anschließend wird Polysilizium und dann wieder SiO₂ geätzt, so, daß Teile der Böden der ersten Gräben G1' freigelegt werden. Anschließend wird dotiertes Polysilizium mit einer Dicke von ca. 250 nm abgeschieden und rückgeätzt, wodurch leitende Strukturen L' mit horizontalen Elementen Lh' und vertikalen Elementen Lv' entstehen, die jeweils eine Gateelektrode Ga1' eines ersten Transistors mit einem ersten Source-Drain-Gebiet 2S/D1' eines zweiten Transistors verbinden (s. Fig 9).

Wie im ersten Ausführungsbeispiel werden anschließend eine dritte isolierende Struktur, Bitleitungen und erste Kontakte von Bitleitungen erzeugt.

In einem dritten Ausführungsbeispiel ist ein drittes Substrat 1*''* aus Silizium in einer an eine Oberfläche O'' des dritten Substrats 1'' angrenzenden ca. 2*µm* dicken Schicht S'' p-dotiert. Die Dotierstoffkonzentration beträgt ca. 10¹⁷cm⁻³. Wie im ersten Ausführungsbeispiel umfaßt die Oberfläche O'' erste Bereiche und zweite Bereiche. Wie im ersten Ausführungsbeispiel umfassen die ersten Bereiche dritte Bereiche und die zweiten Bereiche vierte Bereiche. Ohne Maske wird durch Implantation ein n-dotiertes ca. 150 nm tiefes Gebiet G'' erzeugt. Anschließend wird analog wie im zweiten Ausführungsbeispiel eine erste isolierende Schicht S1'' aus SiO₂ , eine leitende Schicht SL'' aus Polysilizium, eine zweite isolierende Schicht aus SiO₂, erste Gräben G1'' und zweite Gräben G2'' erzeugt (s. Figur 10).

Anschließend wird SiO₂ abgeschieden und rückgeätzt, wodurch die ersten Gräben und die zweiten Gräben mit SiO₂ gefüllt werden (s. Figur 10). Mit Hilfe einer dreizehnten Photolackmaske, die die vierten Bereiche nicht bedeckt, wird zunächst SiO₂, dann Polysilizium und dann SiO₂ geätzt, so daß Teile der Oberfläche freigelegt werden. Die dreizehnte Photolackmaske wird entfernt. Anschließend werden Vertiefungen erzeugt, indem Silizium selektiv zu SiO₂ bis zu einer Tiefe von ca. 300 nm geätzt wird. Übrigbleibende Teile des Gebiets G'' sind als zweite Source/Drain-Gebiete von zweiten Transistoren, zweite Source/Drain-Gebiete von dritten Transistoren und als erste Source/Drain-Gebiete von ersten Transistoren geeignet. Dann wird SiO₂ geätzt, so daß die Flanken und die Böden der ersten Gräben G1'' und der zweiten Gräben G2'' freigelegt werden.

Anschließend werden wie im zweiten Ausführungsbeispiel erste Channel-Stop-Gebiete, zweite Channel-Stop-Gebiete, erste Source/Drain-Gebiete der dritten Transistoren, zweite Source/Drain-Gebiete der ersten Transistoren, erste Source/Drain-Gebiete der zweiten Transistoren, ein Gatedielektrikum, Gateelektroden der ersten Transistoren, Gateelektroden der zweiten Transistoren und Gateelektroden der dritten Transistoren erzeugt. Mit Hilfe einer vierzehnten Photolackmaske, die in den zweiten Bereichen die zweiten Flanken der ersten Gräben und die zweiten Flanken der zweiten Gräben und die dritten Bereiche sowie Teile der vierten Bereiche nicht bedeckt, wird Polysilizium geätzt, wodurch jeweils Gateelektroden von entlang der zweiten Gräben benachbarten ersten Transistoren und jeweils zweite Source-Drain-Gebiete von entlang der zweiten Gräben benachbarten zweiten Transistoren voneinander isoliert werden.

Anschließend werden analog zum zweiten Ausführungsbeispiel leitende Strukturen, Bitleitungen und erste Kontakte von Bitleitungen erzeugt.

In Speicherzellen der drei Ausführungsbeispiele, können Kondensatoren eingebaut werden. Dies wird in einem vierten Ausführungsbeispiel erläutert. Analog wie im ersten Ausführungsbeispiel werden erste Gräben G1*, zweite Gräben G2*, erste Source/Drain-Gebiete 1S/D1* von ersten Transistoren, zweite Source/Drain-Gebiete 3S/D2* von dritten Transistoren, zweite Source/Drain-Gebiete 2S/D2* von zweiten Transistoren, erste Channel-Stop-Gebiete C1*, zweite Channel-Stop-Gebiete, erste Source/Drain-Gebiete 2S/D1* der zweiten Transistoren, erste Source/Drain-Gebiete 3S/D1* der dritten Transistoren, zweite Source/Drain-Gebiete 1S/D2* der ersten Transistoren, ein Gatedielektrikum Gd*, Gateelektroden Ga1* der ersten Transistoren, Gateelektroden Ga2* der zweiten Transistoren, Gateelektroden Ga3* der dritten Transistoren, schreibende Wortleitungen, auslesende Wortleitungen, eine erste isolierende Struktur I1*, eine zweite isolierende Struktur I2* und leitende Strukturen L* mit horizontalen Elementen Lh* und vertikalen Elementen Lv* erzeugt.

Anschließend wird eine ca. 300 nm dicke zweite isolierende Schicht S2* durch Abscheiden von SiO₂ erzeugt. Mit Hilfe einer fünfzehnten Photolackmaske (nicht dargestellt), die Teile der horizontalen Elemente Lh* der leitenden Strukturen L* oberhalb der ersten Source/Drain-Gebiete 1S/D1* der ersten Transistoren nicht bedeckt, wird SiO₂ geätzt, bis die Teile der horizontalen Elemente Lh* der leitenden Strukturen L* oberhalb der ersten Source/Drain-Gebiete 1S/D1* der ersten Transistoren freigelegt werden. Anschließend werden zweite Kontakte K2* von zu erzeugenden ersten Kondensatorplatten P1* erzeugt, indem z.B. Wolfram abgeschieden und rückgeätzt wird.

Anschließend wird z.B. Platin mit einer Dicke von ca. 200 nm abgeschieden. Mit Hilfe einer sechzehnten Photolackmaske (nicht dargestellt), die innerhalb der ersten Bereiche Teile der zweiten isolierenden Schicht S2* oberhalb der zweiten Source/Drain-Gebiete 2S/D2* der zweiten Transistoren und der zweiten Source/Drain-Gebiete 3S/D2* der dritten Transistoren nicht bedeckt, wird Platin mit z.B. *Cl*₂+*O*₂ geätzt, wodurch die ersten Kondensatorplatten P1* erzeugt werden.

Anschließend wird mit einer Dicke von ca. 20 nm Bariumstrontiumtitanat abgeschieden und darüber mit einer Dicke von ca.200 nm Platin abgeschieden. Mit Hilfe einer siebzehnten Photolackmaske (nicht dargestellt), die streifenförmige, parallel zu den ersten Gräben verlaufende, zwischen zu erzeugenden ersten Kontakten K1* angeordnete Bereiche, die die ersten Kondensatorplatten P1* umfassen, nicht bedeckt, wird gleichzeitig Platin und Bariumstrontiumtitanat mit z.B. *Cl*₂+*O*₂ geätzt, wodurch zweite Kondensatorplatten P2* und Kondensatordielektrika Kd* entstehen.

Anschließend werden wie im ersten Ausführungsbeispiel eine dritte isolierende Struktur I3*, erste Kontakte K1* von Bitleitungen B* und Bitleitungen B* erzeugt.

Es sind viele Variationen der Ausführungsbeispiele denkbar, die ebenfalls im Rahmen der Erfindung liegen. Insbesondere können die Abmessungen der beschriebenen Schichten, Gebiete, Bereiche und Gräben an die jeweiligen Erfordernisse angepaßt werden. Dasselbe gilt auch für die vorgeschlagenen Dotierstoffkonzentrationen. Strukturen und Schichten aus SiO₂ können insbesondere durch thermische Oxidation oder durch ein Abscheidungsverfahren erzeugt werden. Polysilizium kann sowohl während als auch nach der Abscheidung dotiert werden. Statt dotiertem Polysilizium lassen sich auch z.B. Metallsilizide und/oder Metalle verwenden. Als Material für die Kondensatordielektrika eignen sich vor allem Dielektrika mit hohen Dielektrizitätskonstanten, wie z.B. Perovskite.

Statt abgeschiedenes SiO₂ rückzuätzen kann zur Erzeugung der ersten isolierenden Struktur auch chemisch-mechanisches Polieren angewandt und anschließend leicht überätzt werden. Dasselbe gilt für die Erzeugung der leitenden Struktur.

## Patentansprüche

1. DRAM-Zellenanordnung,
- mit Speicherzellen, die jeweils einen ersten Transistor, einen zweiten Transistor und einen dritten Transistor umfassen,
- bei der eine Gateelektrode (Ga1) des ersten Transistors mit einem ersten Source/Drain-Gebiet (2S/D1) des zweiten Transistors verbunden ist,
- bei der ein zweites Source/Drain-Gebiet (2S/D2) des zweiten Transistors mit einer schreibenden Bitleitung (B) verbunden ist,
- bei der eine Gateelektrode (Ga2) des zweiten Transistors mit einer schreibenden Wortleitung (WS) verbunden ist,
- bei der eine Gateelektrode (Ga3) des dritten Transistors mit einer auslesenden Wortleitung (WA) verbunden ist,
- bei der ein zweites Source/Drain-Gebiet (1S/D2) des ersten Transistors mit einem ersten Source/Drain-Gebiet (3S/D1) des dritten Transistors verbunden ist,
- bei der ein zweites Source/Drain-Gebiet (3S/D2) des dritten Transistors mit einer auslesenden Bitleitung (B) verbunden ist, dadurch gekennzeichnet, daß
- der erste Transistor, der zweite Transistor und der dritte Transistor vertikale MOS-Transistoren sind.

2. DRAM-Zellenanordnung nach Anspruch 1,
- bei der eine erste Flanke eines in einem Substrat (1) aus Halbleitermaterial befindlichen ersten Grabens (G1) mit einem Gatedielektrikum (Gd) versehen ist,
- bei der eine erste Flanke eines zweiten Grabens (Ga2) mit dem Gatedielektrikum (Gd) versehen ist,
- bei der der erste Graben (G1) und der zweite Graben (G2) im wesentlichen parallel verlaufen,
- bei der die schreibende Wortleitung (WS) entlang des ersten Grabens (G1) verläuft,
- bei der die auslesende Wortleitung (WA) entlang des zweiten Grabens (G2) verläuft,
- bei der die Gateelektrode (Ga2) des zweiten Transistors innerhalb des ersten Grabens (G1) an die erste Flanke (1F1) des ersten Grabens (G1) angrenzt,
- bei der die Gateelektrode (Ga3) des dritten Transistors innerhalb des zweiten Grabens (G2) an eine erste Flanke (2F1) des zweiten Grabens (Ga2) angrenzt.

3. DRAM-Zellenanordnung nach Anspruch 2,
- bei der das erste Source/Drain-Gebiet (2S/D1) des zweiten Transistors an einen Boden des ersten Grabens (G1) angrenzt,
- bei der das erste Source/Drain-Gebiet (3S/D1) des dritten Transistors an einen Boden des zweiten Grabens (G2) angrenzt,
- bei der das zweite Source/Drain-Gebiet (2S/D2) des zweiten Transistors seitlich an die erste Flanke (1F1) des ersten Grabens (G1) angrenzt,
- bei der das zweite Source/Drain-Gebiet (3S/D2) des dritten Transistors seitlich an die erste Flanke (2F1) des zweiten Grabens (G2) angrenzt,
- bei der die schreibende Bitleitung (B) und die auslesende Bitleitung (B) quer zu der schreibenden Wortleitung (WS) und der auslesenden Wortleitung (WA) verlaufen,
- bei der die schreibende Bitleitung (B) oberhalb zweiter erster Source/Drain-Gebiete (2S/D1) und die auslesende Bitleitung (B) oberhalb erster Source/Drain-Gebiete (3S/D1) von dritten Transistoren angeordnet sind.

4. DRAM-Zellenanordnung nach Anspruch 3,
- bei der die Gateelektrode (Ga1) des ersten Transistors an eine zweite Flanke (2F2) des zweiten Grabens (G2) angrenzt und innerhalb des zweiten Grabens (G2) angeordnet ist,
- bei der die zweite Flanke (2F2) des zweiten Grabens (G2) mit dem Gatedielektrikum (Gd) versehen ist,
- bei der das erste Source/Drain-Gebiet (3S/D1) des dritten Transistors mit dem zweiten Source/Drain-Gebiet (1S/D2) des ersten Transistors zusammenfällt,
- bei der ein erstes Source/Drain-Gebiet (1S/D1) des ersten Transistors seitlich an die zweite Flanke (2F2) des zweiten Grabens (G2) angrenzt,
- bei der die Gateelektrode (Ga1) des ersten Transistors mit dem ersten Source/Drain-Gebiet (2S/D1) des zweiten Transistors über eine leitende Struktur (L) verbunden ist,
- bei der die leitende Struktur (L) ein horizontales Element (Lh) und ein vertikales Element (Lv) umfaßt,
- bei der das horizontale Element (Lh) über einem ersten Teil einer ersten isolierenden Schicht (S1), der über dem ersten Source/Drain-Gebiet (1S/D1) des ersten Transistors angeordnet ist, angeordnet ist,
- bei der das vertikale Element (Lv) an eine zweite Flanke (1F2) des ersten Grabens (G1) angrenzt und innerhalb des ersten Grabens (G1) angeordnet ist,
- bei der die auslesende Bitleitung (B) mit der schreibenden Bitleitung (B) zusammenfällt.

5. DRAM-Zellenanordnung nach Anspruch 4,
- bei der das erste Source/Drain-Gebiet (1S/D1) des ersten Transistors seitlich an die zweite Flanke (1F2) des ersten Grabens (G1) angrenzt,
- bei der das erste Source/Drain-Gebiet (1S/D1) des ersten Transistors, das zweite Source/Drain-Gebiet (1S/D2) des ersten Transistors, das erste Source/Drain-Gebiet (2S/D1) des zweiten Transistors, das zweite Source/Drain-Gebiet (2S/D2) des zweiten Transistors, das erste Source/Drain-Gebiet (3S/D1) des dritten Transistors und das zweite Source/Drain-Gebiet (3S/D2) des dritten Transistors von einem ersten Leitfähigkeitstyp dotiert sind,
- bei der das Substrat (1) in einer an eine Oberfläche (O) des Substrats (1) angrenzenden Schicht (S) von einem zweiten, zum ersten Leitfähigkeitstyp entgegengesetzten Leitfähigkeitstyp dotiert ist,
- bei der die Schicht (S) eine erste Dotierstoffkonzentration aufweist,
- bei der ein erstes Channel-Stop-Gebiet (C1) an die zweite Flanke des ersten Grabens (G1) angrenzt und im Substrat (1) angeordnet ist,
- bei der die zweite Flanke des ersten Grabens (G1) mit dem Gatedielektrikum (Gd) versehen ist,
- bei der das erste Channel-Stop-Gebiet (C1) vom zweiten Leitfähigkeitstyp dotiert ist und eine zweite Dotierstoffkonzentration aufweist, die höher als die erste Dotierstoffkonzentration ist.

6. DRAM-Zellenanordnung nach einem der Ansprüche 1 bis 5, bei der benachbarte zweite Source/Drain-Gebiete (2S/D2) von zweiten Transistoren und benachbarte zweite Source/Drain-Gebiete (3S/D2) von dritten Transistoren jeweils durch eine mit isolierendem Material gefüllte Vertiefung voneinander isoliert sind.

7. DRAM-Zellenanordnung nach einem der Ansprüche 1 bis 6,
- bei der Speicherzellen jeweils einen Kondensator umfassen,
- bei der der Kondensator eine erste Kondensatorplatte (P1*), eine zweite Kondensatorplatte (P1*) und ein zwischen der ersten Kondensatorplatte und der zweiten Kondensatorplatte (P2*) angeordnetes Kondensatordielektrikum (Kd*) umfaßt,
- bei der die erste Kondensatorplatte (P1*) mit dem ersten Source/Drain-Gebiet (1 S/D1*) des ersten Transistors verbunden ist.

8. DRAM-Zellenanordnung nach Anspruch 7,
- bei der die erste Kondensatorplatte (P1*) über einen zweiten Kontakt (K2*) mit dem ersten Source/Drain-Gebiet (1S/D1*) des ersten Transistors verbunden und oberhalb des ersten Source/Drain-Gebiets (1S/D1*) des ersten Transistors angeordnet ist,
- bei der die zweite Kondensatorplatte (P2*) oberhalb der ersten Kondensatorplatte (P1*) und unterhalb der Bitleitung (B*) angeordnet ist,
- bei der zweite Kondensatorplatten (P2*) von entlang des ersten Grabens (G1*) benachbarten Kondensatoren verbunden sind.

9. Verfahren zur Herstellung einer DRAM-Zellenanordnung,
- bei dem Speicherzellen, die jeweils einen ersten Transistor, einen zweiten Transistor und einen dritten Transistor umfassen, erzeugt werden,
- bei dem schreibende Wortleitungen (WS) und auslesende Wortleitungen (WA) und quer zu den schreibenden Wortleitungen (WS) und den auslesenden Wortleitungen (WA) schreibende Bitleitungen (B) und auslesende Bitleitungen (B) erzeugt werden,
- bei dem Gateelektroden, erste Source/Drain-Gebiete und zweite Source/Drain-Gebiete erzeugt werden,
- bei dem eine Gateelektrode (Ga1) des ersten Transistors mit einem ersten Source/Drain-Gebiet (2S/D1) des zweiten Transistors verbunden wird,
- bei dem ein zweites Source/Drain-Gebiet (2S/D2) des zweiten Transistors mit einer schreibenden Bitleitung (B) verbunden wird,
- bei dem eine Gateelektrode (Ga2) des zweiten Transistors mit einer schreibenden Wortleitung (WS) verbunden wird,
- bei dem eine Gateelektrode (Ga3) des dritten Transistors mit einer auslesenden Wortleitung (WA) verbunden wird,
- bei dem ein zweites Source/Drain-Gebiet (1S/D2) des ersten Transistors mit einem ersten Source/Drain-Gebiet (3S/D1) des dritten Transistors verbunden wird,
- bei dem ein zweites Source/Drain-Gebiet (3S/D2) des dritten Transistors mit einer auslesenden Bitleitung (B) verbunden wird,
- bei dem der erste Transistor, der zweite Transistor und der dritte Transistor als vertikale Transistoren gebildet werden.

10. Verfahren nach Anspruch 9,
- bei dem in einem Substrat (1) erste Gräben (G1) und zweite Gräben (G2) erzeugt werden, die im wesentlichen parallel zueinander verlaufen,
- bei der erste Flanken (1F1) der ersten Gräben (G1) und erste Flanken (2F1) der zweiten Gräben (G2) mit einem Gatedielektrikum (Gd) versehen werden,
- bei dem die Gateelektrode (Ga2) des zweiten Transistors innerhalb eines ersten Grabens (G1) als Spacer an eine erste Flanke (1F1) des ersten Grabens (G1) angrenzend gebildet wird,
- bei dem die schreibende Wortleitung (WS) entlang des ersten Grabens (G1) verläuft,
- bei dem die Gateelektrode (Ga3) des dritten Transistors innerhalb eines zweiten Grabens (G2) als Spacer an die erste Flanke (2F1) des zweiten Grabens (G2) angrenzend gebildet wird,
- bei dem die auslesende Wortleitung (WA) entlang des zweiten Grabens (G1) verläuft.

11. Verfahren nach Anspruch 10,
- bei dem das erste Source/Drain-Gebiet (2S/D1) des zweiten Transistors so erzeugt wird, daß es an einen Boden des ersten Grabens (G1) angrenzt,
- bei dem das erste Source/Drain-Gebiet (3S/D1) des dritten Transistors so erzeugt wird, daß es an einen Boden des zweiten Grabens (G2) angrenzt,
- bei dem das zweite Source/Drain-Gebiet (2S/D2) des zweiten Transistors so erzeugt wird, daß es seitlich an die erste Flanke (1F1) des ersten Grabens (G1) angrenzt,
- bei der das zweite Source/Drain-Gebiet (3S/D2) des dritten Transistors so erzeugt wird, daß es seitlich an die erste Flanke (2F1) des zweiten Grabens (G2) angrenzt,
- bei dem die schreibende Bitleitung (B) und die auslesende Bitleitung (B) so erzeugt werden, daß sie quer zu der schreibenden Wortleitung (WS) und der auslesenden Wortleitung (WA) verlaufen,
- bei dem die schreibende Bitleitung (B) oberhalb erster Source/Drain-Gebiete (2S/D1) von zweiten Transistoren und die auslesende Bitleitung (B) oberhalb erster Source/Drain-Gebiete (3S/D1) von dritten Transistoren gebildet werden.

12. Verfahren nach Anspruch 11,
- bei dem die zweite Flanke (2F2) des zweiten Grabens (G2) mit dem Gatedielektrikum (Gd) versehen wird,
- bei dem die Gateelektrode (Ga1) des ersten Transistors innerhalb des zweiten Grabens (G2) an eine zweite Flanke (2F2) des zweiten Grabens (G2) angrenzend gebildet wird,
- bei dem das zweite Source/Drain-Gebiet (2S/D2) des zweiten Transistors so erzeugt wird, daß es an den Boden des ersten Grabens (G1) angrenzt,
- bei dem ein erstes Source/Drain-Gebiet (1S/D1) des ersten Transistors so erzeugt wird, daß es seitlich an die zweite Flanke (2F2) des zweiten Grabens (G2) angrenzt,
- bei dem über dem ersten Source/Drain-Gebiet (1S/D1) des ersten Transistors ein horizontales Element (Lh) einer leitenden Strukur (L) erzeugt wird, und zwar so, daß es mit der Gateelektrode (Ga1) des ersten Transistors verbunden wird,
- bei dem an eine zweite Flanke (1F2) des ersten Grabens (G1) angrenzend ein Gatedielektrikum (Gd) erzeugt wird,
- bei dem an die zweite Flanke (1F2) des ersten Grabens (G1) angrenzend innerhalb des ersten Grabens (G1) ein vertikales Element (Lv) der leitenden Struktur (L) erzeugt wird, und zwar so, daß es mit dem ersten Source/Drain-Gebiet (2S/D1) des zweiten Transistors und dem horizontalen Element (Lh) der leitenden Struktur (L) verbunden wird,
- bei dem Bitleitungen (B) erzeugt werden, die jeweils sowohl als die auslesende Bitleitung (B) als auch als die schreibende Bitleitung (B) dienen.

13. Verfahren nach Anspruch 12,
- bei dem das Substrat (1), das Halbleitermaterial enthält, in einer an eine Oberfläche (O) des Substrats (1) angrenzenden Schicht (S) von einem zweiten Leitfähigkeitstyp mit einer ersten Dotierstoffkonzentration dotiert wird,
- bei dem das erste Source/Drain-Gebiet (1S/D1) des ersten Transistors so gebildet wird, daß es seitlich an die zweite Flanke (1F2) des ersten Grabens (G1) angrenzt,
- bei dem ein zweites Source/Drain-Gebiet (3S/D2) des dritten Transistors einer ersten Speicherzelle und ein zweites Source/Drain-Gebiet (2S/D2) des zweiten Transistors einer benachbarten zweiten Speicherzelle so gebildet werden, daß sie aneinander angrenzen oder zusammenfallen,
- bei dem in dem Substrat (1) das erste Source/Drain-Gebiet (1S/D1) des ersten Transistors, das zweite Source/Drain-Gebiet (1S/D2) des ersten Transistors, das erste Source/Drain-Gebiet (2S/D1) des zweiten Transistors, das zweite Source/Drain-Gebiet (2S/D2) des zweiten Transistors, das erste Source/Drain-Gebiet (3S/D1) des dritten Transistors und das zweite Source/Drain-Gebiet (3S/D2) des dritten Transistors durch Implantation erzeugt werden, und zwar so, daß sie von einem ersten, zum zweiten Leitfähigkeitstyp entgegengesetzten Leitfahigkeitstyp dotiert werden,
- bei dem außerhalb des ersten Grabens (G1) an die zweite Flanke des ersten Grabens (G1) angrenzend durch Implantation ein vom zweiten Leitfähigkeitstyp dotiertes erstes Channel-Stop-Gebiet (C1) erzeugt wird, so, daß es eine zweite Dotierstoffkonzentration aufweist, die höher als die erste Dotierstoffkonzentration ist,
- bei dem die Bitleitung (B) oberhalb des ersten Source/Drain-Gebiets (1S/D1) des ersten Transistors, des zweiten Source/Drain-Gebiets (1S/D2) des ersten Transistors, des ersten Source/Drain-Gebiets (2S/D1) des zweiten Transistors, des zweiten Source/Drain-Gebiets (2S/D2) des zweiten Transistors, des ersten Source/Drain-Gebiets (3S/D1) des dritten Transistors und das zweiten Source/Drain-Gebiets des dritten Transistors (3S/D2) verläuft.

14. Verfahren nach Anspruch 13
- bei dem in der Schicht (S) des Substrats (1) ein vom ersten Leitfähigkeitstyp dotiertes Gebiet (G) erzeugt wird,
- bei dem auf der Oberfläche (O) isolierendes Material aufgebracht und geätzt wird, so, daß eine strukturierte erste isolierende Schicht (S1) entsteht,
- bei dem aus dem Gebiet (G) durch die Erzeugung der ersten Gräben (G1) und der zweiten Gräben (G2) das erste Source/Drain-Gebiet (1S/D1) des ersten Transistors, das zweite Source/Drain-Gebiet (2S/D2) des zweiten Transistors und das zweite Source/Drain-Gebiet (3S/D2) des dritten Transistors entstehen,
- bei dem nach der Erzeugung des ersten Grabens (G1) und des zweiten Grabens (G2) das erste Channel-Stop-Gebiet (C1) durch schräge Implantation erzeugt wird,
- bei dem nach der Erzeugung des ersten Channel-Stop-Gebiets (C1) bei der Implantation des ersten Source/Drain-Gebietes (3S/D1) des dritten Transistors, des zweiten Source/Drain-Gebietes (1S/D2) des ersten Transistors und des ersten Source/Drain-Gebietes (2S/D1) des zweiten Transistors eine streifenförmige fünfte Photolackmaske verwendet wird, die zwischen benachbarten Bitleitungen (B) liegende zweite Bereiche (B2) vor Implantation schützt,
- bei dem zur Erzeugung der Gateelektrode (Ga1) des ersten Transistors, der Gateelektrode (Ga2) des zweiten Transistors und der Gateelektrode (Ga3) des dritten Transistors nach der Erzeugung des Gatedielektrikums (Gd), leitendes Material abgeschieden und rückgeätzt wird, so daß die Gateelektrode (Ga1) des ersten Transistors, die Gateelektrode (Ga2) des zweiten Transistors und die Gateelektrode (Ga3) des dritten Transistors in Form von Spacern entstehen,
- bei dem mit Hilfe einer sechsten Photolackmaske entlang der zweiten Gräben (G2) benachbarte erste Gateelektroden (Ga1) durch Ätzen des leitenden Materials voneinander isoliert werden,
- bei dem der erste Graben (G1) und der zweite Graben (G2) anschließend mit isolierendem Material aufgefüllt werden,
- bei dem nach der Erzeugung der leitenden Struktur (L) eine dritte isolierende Struktur (I3) aus isolierendem Material erzeugt wird, indem mit Hilfe einer zehnten Photolackmaske isolierendes Material geätzt wird, so, daß das zweite Source/Drain-Gebiet (3S/D2) des dritten Transistors und das zweite Source/Drain-Gebiet (2S/D2) des zweiten Transistors teilweise freigelegt werden,
- bei dem anschließend leitendes Material aufgebracht wird und mit Hilfe einer elften Photolackmaske so strukturiert wird, daß die Bitleitungen (B) und Kontakte (K) der Bitleitungen (B) entstehen.

15. Verfahren nach Anspruch 14,
- bei dem nach der Erzeugung der ersten isolierenden Struktur (I1) eine zweite isolierende Struktur (I2) erzeugt wird, indem isolierendes Material aufgebracht und mit Hilfe einer siebten Photolackmaske, die die zweiten Flanken der ersten Gräben (G1) und die zweiten Flanken (2F2) der zweiten Gräben (G2) nicht bedeckt, geätzt wird, so, daß die erste Gateelektrode (Ga1) teilweise freigelegt wird,
- bei dem mit Hilfe einer achten Photolackmaske, die die zweiten Flanken (1F2) der ersten Gräben (G1) nicht bedeckt, das erste Source/Drain-Gebiet (2S/D1) des zweiten Transistors teilweise freigelegt wird, und anschließend zur Erzeugung der leitenden Struktur (L) leitendes Material abgeschieden und strukturiert wird.

16. Verfahren nach Anspruch 14
- bei dem vor dem Ätzen des auf der Oberfläche (O') aufgebrachten isolierenden Materials über das isolierende Material eine leitende Schicht (S1') aufgebracht wird,
- bei dem nach dem Auffüllen des ersten Grabens (G1') und des zweiten Grabens (G2') mit isolierendem Material mit Hilfe einer zwölften Photolackmaske, die die zweiten Flanken der ersten Gräben (G1') und die zweiten Flanken (2F2*) der zweiten Gräben (G2') bedeckt, die leitende Schicht (S1') teilweise entfernt wird,
- bei dem anschließend isolierendes Material aufgebracht und mit Hilfe einer dreizehnten Photolackmaske, die die zweiten Flanken (1F2') der ersten Gräben (G1) nicht bedeckt, strukturiert wird,
- bei dem anschließend das erste Source/Drain-Gebiet (2S/D1') des zweiten Transistors durch Ätzen freigelegt wird,
- bei dem anschließend zur Erzeugung der leitenden Struktur (L') leitendes Material abgeschieden und strukturiert wird.

17. Verfahren nach Anspruch 15 oder 16, bei dem zur Isolation benachbarter zweiter Source/Drain-Gebiete (2S/D2) der zweiten Transistoren das Gebiet (G) mit Hilfe einer ersten Photolackmaske, die zwischen den zweiten Source/Drain-Gebieten (2S/D2) der zweiten Transistoren liegende vierte Bereiche (B4) bedeckt, durch Implantation erzeugt wird.

18. Verfahren nach Anspruch 15 oder 16,
- bei dem das Gebiet (G'') ohne Maske durch Implantation erzeugt wird,
- bei dem zur Isolation benachbarter zweiter Source/Drain-Gebiete zweiter Transistoren Vertiefungen (V) erzeugt und mit isolierendem Material gefüllt werden.

19. Verfahren nach einem der Ansprüche 9 bis 18 ,
- bei dem für die Speicherzellen jeweils ein Kondensator mit einer ersten Kondensatorplatte (P1*), einem Kondensatordielektrikum (Kd*) und einer zweiten Kondensatorplatte (P2*) erzeugt wird,
- bei dem die erste Kondensatorplatte (P1*) mit dem ersten Source/Drain-Gebiet (1S/D1*) des ersten Transistors verbunden wird.

20. Verfahren nach Anspruch 19,
- bei dem die erste Kondensatorplatte (P1*) oberhalb des ersten Source/Drain-Gebiets (1S/D1*) des ersten Transistors erzeugt wird,
- bei dem ein zweiter Kontakt (K2*) erzeugt wird, der die erste Kondensatorplatte (P1*) mit dem ersten Source/Drain-Gebiet (1S/D1*) des ersten Transistors verbindet,
- bei dem das Kondensatordielektrikum (Kd*) oberhalb der ersten Kondensatorplatte (P1*), die zweite Kondensatorplatte (P2*) oberhalb des Kondensatordielektrikums (Kd*) und die Bitleitung (B*) oberhalb der zweiten Kondensatorplatte (P2*) erzeugt werden,
- bei dem zweite Kondensatorplatten (P2*) von entlang des ersten Grabens (G1*) benachbarten Kondensatoren verbunden werden.
